# EUROPÄISCHE PATENTSCHRIFT

(11) **EP 1 665 914 B1**
(45) Veröffentlichungstag und Bekanntmachung des Hinweises auf die Patenterteilung: **31.10.2007**
(21) Anmeldenummer: 04765410.8
(22) Anmeldetag: 20.09.2004
(51) Int. Cl.: H05K 3/30, H05K 1/11, H05K 1/18, H05K 13/04

(54) **LEITERPLATTE MIT EINER HALTEVORRICHTUNG ZUM HALTEN BEDRAHTETER ELEKTRONISCHER BAUTEILE, VERFAHREN ZUR HERSTELLUNG EINER SOLCHEN LEITERPLATTE UND DEREN VERWENDUNG IN EINEM LÖTOFEN**
PRINTED CIRCUIT BOARD COMPRISING A HOLDING DEVICE FOR RETAINING WIRED ELECTRONIC COMPONENTS, METHOD FOR THE PRODUCTION OF SUCH A PRINTED CIRCUIT BOARD, AND USE THEREOF IN A SOLDERING FURNACE
CARTE DE CIRCUITS IMPRIMES COMPRENANT UN DISPOSITIF DE MAINTIEN CONCU POUR MAINTENIR DES COMPOSANTS ELECTRONIQUES CABLES, PROCEDE POUR PRODUIRE UNE TELLE CARTE DE CIRCUITS IMPRIMES ET SON UTILISATION DANS UN FOUR A BRASER

(30) Priorität: 23.09.2003 DE 10344261
(43) Veröffentlichungstag der Anmeldung: 07.06.2006
(73) Patentinhaber: Endress + Hauser GmbH + Co. KG, 79689 Maulburg (DE)
(72) Erfinder: BIRGEL, Dietmar, 79650 Schopfheim (DE); BURGER, Paul, 79650 Schopfheim (DE); HAUPTVOGEL, Karl-Peter, F-68870 Bartenheim (FR)
(74) Vertreter: Andres, Angelika Maria
(86) Internationale Anmeldenummer: PCT/EP2004/010524
(87) Internationale Veröffentlichungsnummer: WO 2005/032224

(56) Entgegenhaltungen:
- EP-A- 0 457 984
- WO-A-88/07317
- DE-A- 3 411 031
- FR-A- 2 618 191
- GB-A- 1 226 845
- US-A- 4 185 378
- US-B1- 6 530 279
- PATENT ABSTRACTS OF JAPAN Bd. 1999, Nr. 08, 30. Juni 1999 (1999-06-30) & JP 11 074631 A (MITSUBISHI ELECTRIC CORP), 16. März 1999 (1999-03-16)
- PATENT ABSTRACTS OF JAPAN Bd. 1998, Nr. 06, 30. April 1998 (1998-04-30) & JP 10 041593 A (IBIDEN CO LTD), 13. Februar 1998 (1998-02-13)

## Beschreibung

Die Erfindung betrifft eine Leiterplatte mit einer Haltevorrichtung zum Halten bedrahteter elektronischer Bauteile, ein Verfahren zur Herstellung einer solchen Leiterplatte und deren Verwendung in einem Lötofen.

Es sind verschiedene Verfahren und Vorrichtungen bekannt, mit denen bedrahtete elektronische Bauteile auf Leiterplatten so fixiert werden können, daß sie beim Bestücken oder beim Transport der Leiterplatten mit den darauf bestückten Bauteile zu einer Lötanlage nicht verrutschen oder sonst wie ihre Position verändern, vgl.

Patent Abstracts of Japan, Bd. 1998, Nr 06, 30.04.1998; DE-A- 34 11031, US-A- 4 185 378, WO-A-8 807 317 and US-A-6 530 279.

Unter bedrahteten Bauteilen sollen hier all solche elektronischen Bauteile verstanden werden, die wenigstens einen Anschlußdraht oder einen Anschlußpin aufweisen, der durch bzw. in eine entsprechende übliche Anschlußbohrung der Leiterplatte gesteckt und an bzw. mit einer gewünschten Kontaktstelle verlötet wird und so die elektrischen Kontaktierung des Bauteils darstellt. Bedrahtete Bauteile in diesem Sinne können daher auch Steckerleisten, Verbindungsdrähte oder -Litzen aber auch Transformatoren und andere aktive bzw. passive elektronische Bauteile sein.

Besonders bei Bauteilen großer Masse oder mit ungleicher Masseverteilung reicht das einfache Ein- bzw. Durchstecken der Anschlußdrähte oder Anschlußpins nicht aus, um eine sichere mechanische Befestigung für die Bauteile bei einem Transport zur oder durch eine automatische Lötanlage zu gewährleisten. Es hat sich gezeigt, daß bedrahtete Bauteile der beschriebenen Art auf holpernden oder ruckenden Transportbändern auf dem Weg zu einer automatischen Lötanlage oder auf dem Weg durch die automatischen Lötanlage aus der Leiterplatte herausgerüttelt werden. Es sind auch Fälle bekannt geworden, wo die besagten bedrahteten Bauteile in einer Wellenlötanlage durch die Lotwelle aus der Leiterplatte herausgedrückt wurden. Selbst wenn die Bauteile unter den angegebenen ungünstigen Bedingungen nicht vollständig aus der Leiterplatte herausfallen, kann es passieren, daß sie eine unerwünschte Lage oder Position auf der Leiterplatte einnehmen.

Um diesen Problemen abzuhelfen, wurden bisher die in Frage kommenden Bauteile beispielsweise auf die Leiterplatte geklebt oder mit Snap-In-Halterungen auf der Leiterplatte gehalten. Diese Verfahren sind jedoch aufwendig und mit zusätzlichen Kosten verbunden, da sie einen extra Arbeitsschritt für diese speziellen Bauteile erfordern.

Der Erfindung liegt daher die Aufgabe zugrunde, eine Leiterplatte zu schaffen, die eine Haltevorrichtung zum Festhalten des Anschlußdrahtes oder -pins von Bauteilen aufweist und so die oben beschriebenen Nachteile vermeidet, ohne daß die betrachteten Bauteile durch Kleben oder oder zusätzlich auf der Leiterplatte angebrachte Halteelemente befestigt werden müssen.

Diese Aufgabe wird gelöst durch eine Leiterplatte mit wenigstens einer Anschlußbohrung zur Aufnahme eines Anschlußdrahtes oder -pins eines elektronischen Bauteils mit einem vorgegebenen Draht- bzw. Pindurchmesser, bei der eine Haltevorrichtung zum Festhalten des Anschlußdrahtes oder -pins vorgesehen ist, die eine Verengung im Querschnitt eines Teils der Anschlußbohrung auf einen Durchmesser ist, der kleiner ist als der Durchmesser des Anschlußdrahtes oder -pins,
dadurch gekennzeichnet, daß die Verengung durch zwei Bohrungen herbeigeführt wird.

Andere Ausführungsformen der Leiterplatte nach der Erfindung umfassen zwei Bohrungen, durch die die Verengung herbeigeführt wird, wobei in besonderen Weiterbildungen dieser Leiterplatte nach der Erfindung zwei gleichgerichtete Bohrungen mit unterschiedlichen Durchmessern oder zwei gegenläufige Bohrungen oder zwei gegenläufige und zueinander versetzte Bohrungen vorgesehen sind.

Die oben beschriebene Aufgabe wird weiterhin gelöst durch ein erfindungsgemäßes Verfahren zum Herstellen einer Leiterplatte mit wenigstens einer Anschlußbohrung zur Aufnahme eines Anschlußdrahtes oder -pins eines elektronischen Bauteils mit einem vorgegebenen Draht- bzw. Pindurchmesser sieht vor, daß :
- die Leiterplatte wird mit wenigstens einer Lage bzw. Schicht hergestellt;
- an der für die Anschlußbohrung gewünschten Stelle wird mit einem Bohrwerkzeug mit einem gewünschten Durchmesser ein Sackloch in die Leiterplatte gebohrt;
- anschließend wird mit einem mit einem Bohrwerkzeug mit einem Durchmesser, der kleiner ist als der Draht- bzw. Pindurchmesser, der Grund der Sacklochbohrung durchbohrt, so daß durch die Verengung des Querschnitts eines Teils der Anschlußbohrung eine Haltevorrichtung zum Festhalten des Anschlußdrahtes oder -pins gebildet wird. Bei noch einer weiteren Ausführungsform des erfindungsgemäßen Verfahrens zum Herstellen einer Leiterplatte mit wenigstens einer Anschlußbohrung zur Aufnahme eines Anschlußdrahtes oder-pins eines elektronischen Bauteils mit einem vorgegebenen Draht- bzw. Pindurchmesser wird :

- die Leiterplatte mit wenigstens einer Lage bzw. Schicht hergestellt;
- an der für die Anschlußbohrung gewünschten Stelle von einer ersten Oberfläche der Leiterplatte her mit einem Bohrwerkzeug mit einem gewünschten Durchmesser ein erstes Sackloch in die Leiterplatte gebohrt;
- von einer zweiten Oberfläche der Leiterplatte her ein zweites Sackloch in die Leiterplatte gebohrt, das zu dem ersten Sackloch geringfügig verschoben angeordnet ist und das das erste Sackloch trifft, so daß durch den Versatz der beiden Sacklöcher zueinander eine Restriktion gebildet, die eine Haltevorrichtung zum Festhalten des Anschlußdrahtes oder -pins darstellt.

Noch ein weiteres Verfahren nach der Erfindung zum Herstellen einer Leiterplatte mit wenigstens einer Anschlußbohrung zur Aufnahme eines Anschlußdrahtes oder -pins eines elektronischen Bauteils mit einem vorgegebenen Draht- bzw. Pindurchmesser sieht vor, daß :
- die Leiterplatte mit wenigstens einer Lage bzw. Schicht hergestellt wird;
- an der für die Anschlußbohrung gewünschten Stelle von einer ersten Oberfläche der Leiterplatte her mit einem Bohrwerkzeug mit einem gewünschten Durchmesser ein erstes Sackloch in die Leiterplatte gebohrt wird;
- von einer zweiten Oberfläche der Leiterplatte her ein zweites Sackloch in die Leiterplatte gebohrt wird, das zu dem ersten Sackloch im wesentlichen achsparallel angeordnet ist und das das erste Sackloch trifft aber nicht durchdringt, so daß in einem Teilbereich der Anschlußbohrung, wo die beiden Sacklöcher aufeinandertreffen eine Restriktion gebildet wird, die eine Haltevorrichtung zum Festhalten des Anschlußdrahtes oder -pins darstellt.

Der besondere Vorteil der Erfindung liegt darin, daß sie bisher übliche und entweder an die bedrahteten Bauteile oder auf die Leiterplatte zusätzlich anzubringende Halteelemente, wie z. B. Klebepunkte, Snap-In-Halterungen etc. zur Fixierung kritischer bedrahteter Bauteile vermeidet. Solche zusätzlichen Haltelemente bedeuten immer einen oder sogar mehrere zusätzliche Arbeitschritte und Kosten beim Bestücken und eventuell beim Löten der Leiterplatte. Die Erfindung bietet demgegenüber eine Lösung an, die nur die Leiterplatte selbst betrifft und die zudem ohne zusätzliche Aufbauten auf der Oberfläche der Leiterplatte auskommt. Die erfindungsgemäßen Folien sind wie die erfindungsgemäß gestalteten Anschlußbohrungen Bestandteil der Leiterplatte und stellen keine extra Aufbauten oder Anbauten zur Leiterplatte dar. Leichtes Eindrücken der betreffenden Anschlußpins in eine erfindungsgemäße Anschlußbohrung der Leiterplatte und gegen den Widerstand der in der Anschlußbohrung vorgesehenen Verengung reicht aus, das betrachtete Bauteil mechanisch sicher auf der Leiterplatte zu befestigen.

Die Leiterplatte nach der Erfindung eignet sich in besonderer Weise für automatische Lötanlagen, insbesondere für Wellenlötanlagen und Reflow-Lötöfen. Gerade beim den letzteren bietet sie die Gewähr, daß auch bei dem neuen sogenannten "Überkopf-Lötverfahren", das auch "Backside-Reflow"-Verfahren genannt wird, überkopf und unterhalb der Leiterplatte im Reflow-Lötofen hängende thermisch kritische bedrahtete Bauteile, nicht aus den Anschlußbohrungen herausfallen.

Die Erfindung wird nachfolgend genauer erläutert und anhand verschiedener, in der beigefügten Zeichnung dargestellter Ausführungsbeispiele beschrieben.

Dabei zeigen:
- Fig. 1:: ein erstes Ausführungsbeispiel einer Leiterplatte nach der Erfindung in einer schematischen Schnittdarstellung;
- Fig. 2:: ein zweites Ausführungsbeispiel der Leiterplatte nach der Erfindung in einer schematischen Schnittdarstellung;
- Fig. 3:: ein drittes Ausführungsbeispiel der Leiterplatte nach der Erfindung in einer schematischen Draufsicht;
- Fig. 4:: ein viertes Ausführungsbeispiel der Leiterplatte nach der Erfindung in einer schematischen Draufsicht;
- Fig. 5:: ein fünftes Ausführungsbeispiel der Leiterplatte nach der Erfindung in einer schematischen Draufsicht;
- Fig. 6:: ein sechstes Ausführungsbeispiel der Leiterplatte nach der Erfindung in einer schematischen Schnittdarstellung;
- Fig. 7:: ein siebtes Ausführungsbeispiel der Leiterplatte nach der Erfindung in einer schematischen Schnittdarstellung;
- Fig. 8:: ein achtes Ausführungsbeispiel der Leiterplatte nach der Erfindung in einer schematischen Schnittdarstellung;
- Fig. 9:: ein neuntes Ausführungsbeispiel der Leiterplatte nach der Erfindung in einer schematischen Schnittdarstellung; und
- Fig. 10:: ein zehntes Ausführungsbeispiel der Leiterplatte nach der Erfindung in einer schematischen Schnittdarstellung.

Zur Vereinfachung sind in der Zeichnung gleiche Elemente oder Baugruppen der verschiedenen Ausführungsbeispiele mit gleichen Bezugszeichen versehen.

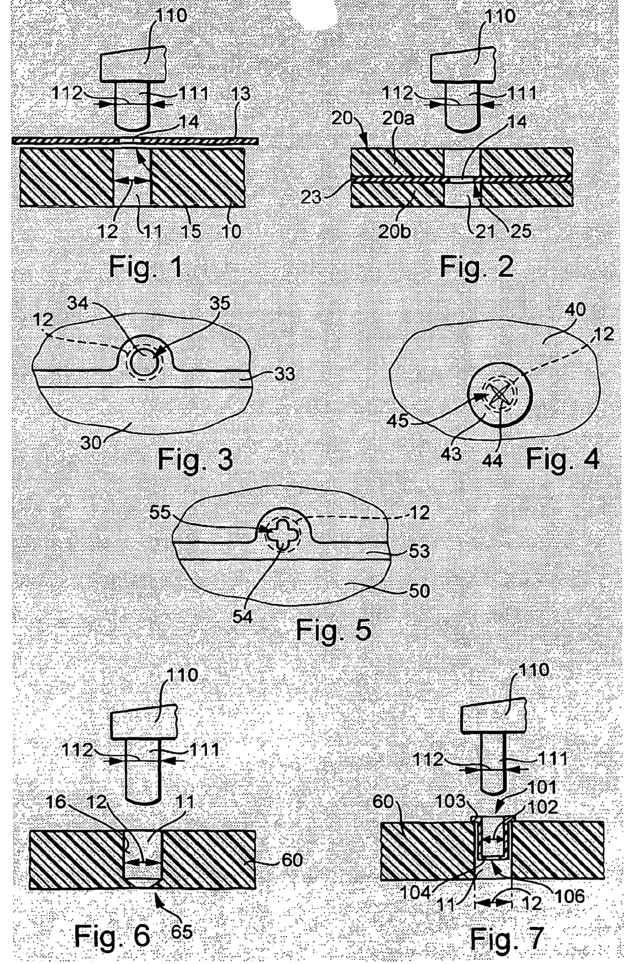

In Fig. 1 ist ein Leiterplatte 10 ausschnittweise dargestellt, die eine durchgehende Anschlußbohrung 11 aufweist zur Aufnahme eines Anschlußpins 111 eines bedrahteten elektrischen bzw. elektronischen Bauteils 110. Bisher war es üblich, einen Durchmesser 12 der Anschlußbohrung 11 geringfügig größer als den Durchmesser 112 des Anschlußpins 111 zu bohren. Das erlaubt zwar bequemes Einstecken des Anschlußpins 111 in die Anschlußbohrung 11, führt aber bei Vibrationen oder Rütteln zum Herausfallen des Bauteils 110, wenn es nicht durch zusätzliche Maßnahmen an der Leiterplatte 10 befestigt ist.

Um dem abzuhelfen, ist bei dem hier dargestellten Ausführungsbeispiel erfindungsgemäß eine Folie 13 vorgesehen, die beispielsweise auf einer Oberfläche der Leiterplatte 10 aufgebracht wird. Die Folie 13, die nach der Erfindung auf die in ihren Lagen fertig aufgebaute und bereits mit der Anschlußbohrung 11 versehene Leiterplatte 10 aufgebracht wird, überdeckt und verschließt zunächst die Anschlußbohrung 11. Die Folie wird auf der Leiterplatte 10 in üblicher Weise, beispielsweise durch Kaschieren, dauerhaft aufgebracht.

Anschließend wird die Folie 13 im Bereich der Anschlußbohrung 11 geöffnet, wobei die Öffnung 14 derart gestaltet ist, daß sie eine Verengung 15 im Querschnitt eines Teils der Anschlußbohrung 11 bildet. Das Material und die Dicke der Folie 13 sowie die Größe und Form ihrer Öffnung 14 sind zweckmäßigerweise so gewählt, daß der jeweilige Anschlußpin 111 des betrachteten Bauteils 110 Da die Verengung 15 kleiner ist als der Durchmesser 112 des Anschlußpins 111 des Bauteils 110, wird der Anschlußpin 111 in der Anschlußbohrung 11 fest verklemmt und das Bauteil 110 gegen Herausfallen gesichert.

Bei dem in Fig. 1 dargestellten Ausführungsbeispiel der Erfindung ist die Folie 13, mittels der die Verengung 15 realisiert wird, auf der Bestückungsseite der Leiterplatte 10 angeordnet. Selbstverständlich ist es auch möglich, die Folie 13 auf der anderen Seite der Leiterplatte 10 anzubringen.

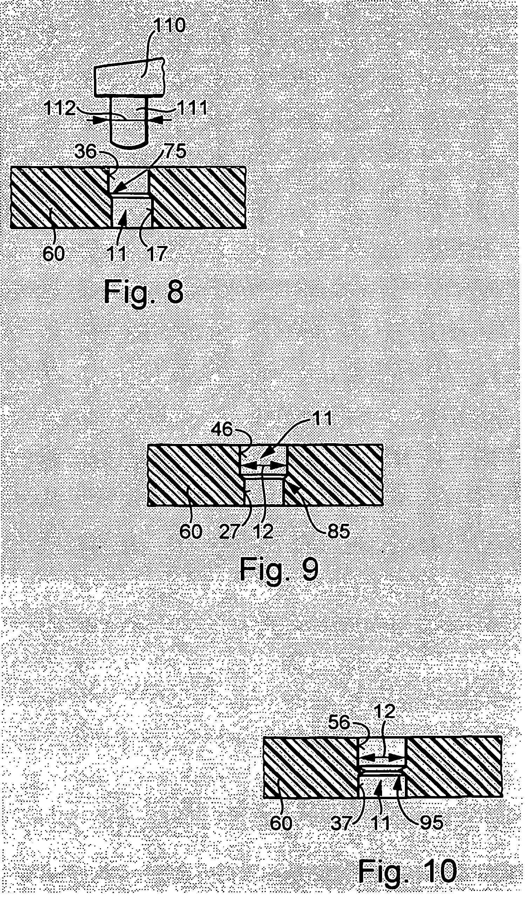

Fig. 2 zeigt ein anderes Ausführungsbeispiel der erfindungsgemäßen Leiterplatte 20, die hier ausschnittweise dargestellt ist. Eine an sich durchgehende Anschlußbohrung 21 zur Aufnahme des Anschlußpins 111 des bedrahteten Bauteils 110 ist etwa in der Mitte der Leiterplatte 20 durch eine als Zwischenlage in der Leiterplatte 20 angeordnete Folie 23 verengt. Eine in der Folie 23 angebrachte Öffnung 24 ist in ihrem Durchmesser kleiner als der Durchmesser 112 des betreffenden Anschlußpins 111 des bedrahteten Bauteils 110. Eine Verengung 25 der Anschlußbohrung 21, die dadurch gebildet wird, hält den in die Anschlußbohrung 21 gesteckten Anschlußpin 111 des Bauteils 110 und verklemmt ihn.

Sinnvollerweise werden die zwei durch die Folie 23 getrennten Teile der Leiterplatte 20 zunächst mit der Anschlußbohrung 21 versehen. Nach Zwischenlegen der Folie 23 oder dem Aufbringen der Folie 23 auf eine der Teile der Leiterplatte 20 werden die Teile zu der in Fig. 2 dargestellten Anordnung zusammengefügt.

In Fig. 3 ist ein weiteres Ausführungsbeispiel einer Leiterplatte nach der Erfindung dargestellt. Die Leiterplatte 30 ist hier ausschnittleise in einer Draufsicht gezeigt. Ähnlich der Fig. 1 dargestellten Leiterplatte ist hier ebenfalls eine Folie 33 auf einer Seite der Leiterplatte 30 angebracht. Eine Öffnung 34 in der Folie 33 hat einen kleineren Durchmesser als die von der Folie 33 überdeckte Anschlußbohrung 11, die hier durch eine gestrichelte Linie veranschaulicht wird. Die Folie 33, wie sie in Fig. 3 dargestellt ist, kann beispielsweise eine Kupfer-Kaschierung im Sinne einer Leiterbahn sein, so daß sie eine Verengung 35 zum Festhalten des Anschlußpins 111 des Bauteils 110 (siehe dazu Fig. 1 und 2) direkt dort zur Verfügung stellt, wo der Anschlußpins 111 dann auch gelötet wird.

Der Einfachheit halber ist in den Fig. 3 bis 5 das Bauteil 110 mit dem in die jeweilige Anschlußbohrung zu steckenden Anschlußpin 111 nicht dargestellt. Es wird dazu auf die Fig. 1 und 2 bzw. auf die nachfolgend besprochenen Fig. 6 bis 8 verwiesen.

Fig. 4 zeigt noch ein weiteres Ausführungsbeispiel einer Leiterplatte nach der Erfindung. Die Leiterplatte 40 ist hier dargestellt. Wiederum ist hier eine Folie 43 auf einer Seite der Leiterplatte 40 angebracht. Eine Öffnung 44 in der Folie 43, die bei diesem Ausführungsbeispiel durch sich kreuzende Schlitze gebildet wird, stellt eine Verengung 45 der Anschlußbohrung 11, die hier durch eine gestrichelte Linie veranschaulicht wird, dar. Die Folie 43 ist bei diesem Ausführungsbeispiel eine knappe, punkförmige Überdeckung der Anschlußbohrung 11.

In Fig. 5 ist noch ein anderes Ausführungsbeispiel einer Leiterplatte nach der Erfindung ähnlich den Darstellungen in den Fig. 3 und 4 ausschnittweise in einer Draufsicht dargestellt. Hier ist eine auf der Leiterplatte 50 angebrachte Folie 53 aus einem elektrisch leitenden Material, wie beim Ausführungsbeispiel der Leiterplatte 30 nach der Fig. 3. Im Unterschied zur loch-ähnlichen Öffnung 34 der Folie 33 bei der Leiterplatte 30 nach der Fig. 3 und der geschlitzten Öffnung 44 der Folie 43 der Fig. 4 ist bei der in Fig. 5 dargestellten Folie 53 eine aus mehreren, sich überdeckenden Löchern gebildete Öffnung 54 gezeigt. Durch die dadurch an ihrem Rand gebildeten und in die Öffnung 54 hineinragenden Kanten wird auch hier eine Verengung 55 zum Festhalten des Anschlußpins 111 des Bauteils 110 (siehe dazu Fig. 1 und 2) in der Anschlußbohrung 11 erreicht.

Die in den Fig. 1-5 dargestellte Folie 13; 23; 33; 43 kann aus elektrisch leitendem oder nichtleitendem Material sein. Als leitendes Material kann sie dann beispielsweise für Lötpunkte verwendet werden. Andererseits ist auch vorstellbar, daß keine fertige Folie sondern ein Film aus einem geeigneten Material auf die Leiterplatte aufgebracht werden kann, der zu einer Folie aushärtet.

Die Öffnungen 14, 24, 34, 44 und 54 in den Folien 13, 23, 33, 43 und 53 der Fig. 1 bis 5 werden beispielsweise durch Stanzen oder durch Schneiden mit einem Laserstrahl hergestellt.

Fig. 6 zeigt eine Leiterplatte 60 nach der Erfindung, bei der die Anschlußbohrung 11 als einseitige aber nicht vollständig durch die Leiterplatte 60 hindurch gebohrte Bohrung 16 ausgeführt ist. Wie in Fig. 6 dargestellt, bleibt in diesem Fall ein Rand als Verengung 65 gegenüber dem Durchmesser 12 der Anschlußbohrung 11 stehen, der kleiner ist als der Durchmesser 112 des Anschlußpins 111 des betrachteten Bauteils 110. Auf diese Weise wird der Anschlußpin 111 und das betrachtete Bauteil 110 sicher in Anschlußbohrung 11 und damit auf der Leiterplatte 60 gehalten.

In Fig. 7 ist ein anderes Ausführungsbeispiel der erfindungsgemäßen Leiterplatte 60 dargestellt. Ähnlich der Leiterplatte 60 in Fig. 6 und im Gegensatz zu den Leiterplatten 10 bis 50 hat die hier gezeigte Leiterplatte keine Folie zur Bildung einer Verengung des lichten Querschnitts der Anschlußbohrung. Bei der Leiterplatte 70 wird eine gewünschte Verengung 106 durch eine becherförmige sehr dünnwandige Hülse 101 erreicht, die in die Anschlußbohrung 11 eingesetzt wird. Die Hülse 101 ist so gestaltet, das ihr Innendurchmesser 102 geringfügig größer als der Durchmesser 112 des Anschlußpins 111 des betrachteten Bauteils 110 ist. Damit die Hülse 101 beim Einsetzen des Anschlußpins 111 nicht durch die Anschlußbohrung 11 gedrückt wird, hat sie einen Kragen 103, der auf der Leiterplatte 70 aufliegt und sie am Durchrutschen hindert. Bodenseitig weist die becherförmige Hülse 101 eine Öffnung 104 auf, deren Durchmesser kleiner als der Durchmesser 112 des Anschlußpins 111 des betrachteten Bauteils 110 ist. Beim Einsetzen des Anschlußpins 111 kann dieser gegen den Widerstand der sich verformenden Hülse 101 durch deren Öffnung 104 gedrückt werden. Die Hülse 101 wird dadurch verformt und klemmt den betrachteten Anschlußpins 111 in der Anschlußbohrung 11 fest.

Im Gegensatz zu den bisher vorgestellten Ausführungsbeispielen der Leiterplatte nach der Erfindung nach den Fig. 1 bis 7, bei denen Anschlußbohrungen durch eine einzeln gebohrte Bohrung erreicht werden, beschäftigen sich die nachfolgend vorgestellten Ausführungsbeispiele der erfindungsgemäßen Leiterplatte mit einer Anschlußbohrung, die aus zwei einzeln gebohrten Bohrungen gebildet wird.

In Fig. 8 ist ein anderes Ausführungsbeispiel der Leiterplatte 60 dargestellt, bei der die Anschlußbohrung 11 aus zwei gegenläufig und zueinander leicht versetzt gebohrten Bohrungen 17 und 36 gebildet wird. Dort, wo die beiden Bohrungen 17 und 36 sich treffen, wird durch den Versatz eine Verengung 75 gebildet. Jede der Bohrungen 17 und 36 hat einen Durchmesser, der größer ist als der Durchmesser 112 des Anschlußpins 111 des betrachteten Bauteils110. Die durch den Versatz der Bohrungen 17 und 36 gebildete Verengung 75 klemmt den Anschlußpin 111 fest und sorgt für einen sicheren Sitz des Bauteils 110 auf der Leiterplatte 60.

Fig. 9 zeigt noch ein anderes Ausführungsbeispiel der Leiterplatte 60, bei der die Anschlußbohrung 11 aus zwei Bohrungen 27 und 46 gebildet wird. Im Gegensatz zur Leiterplatte nach Fig. 8 handelt es sich hier um zwei fluchtende Bohrungen 27 und 46 die zueinander gegenläufig von unterschiedlichen Seiten der Leiterplatte 60 her gebohrt werden können oder quasi überdeckend von einer vorbestimmten Seite der Leiterplatte 60 her. Wichtig ist nur, das eine der Bohrungen, in der gewählten Darstellung ist es die Bohrung 27, einen kleineren Durchmesser als die andere Bohrung aufweist, wobei der größere Durchmesser, der dem Durch 12 der oben bereits beschriebenen Anschlußbohrungen 11 entspricht, etwas größer als der Durchmesser 112 des Anschlußpins 111 des betrachteten Bauteils110 (siehe dazu die Fig. 6-8) und der kleinere Durchmesser der Bohrung 27 kleiner als der Durchmesser 112 des Anschlußpins 111 des betrachteten Bauteils110 sind.

Durch den Übergang einem größeren auf einen kleineren Durch in der Anschlußbohrung 11 wird eine Verengung 85 erzielt, die den Anschlußpin 111 des betrachteten Bauteils 110 (siehe dazu Fig. 6-8) festklemmt und einen sicheren Sitz des Bauteils 110 auf der Leiterplatte 60 ermöglicht.

In Fig. 10 ist ein noch ein weiteres Ausführungsbeispiel der Leiterplatte 60 dargestellt, bei der die Anschlußbohrung 11 aus zwei gegenläufig gebohrten 37 und 56 gebildet wird, die zueinander fluchten und den gleichen Durchmesser 12 aufweisen. Die Bohrung, beispielsweise die Bohrung 37, die zuerst gebohrt wird, wird als Sacklochbohrung ausgeführt, die die Leiterplatte 60 nicht durchdringt. Die andere Bohrung, im betrachteten Fall die Bohrung 56, die fluchtend dazu angesetzt wird, durchdringt die zuerst gebohrte Bohrung 37 nicht vollständig sondern nur in ihrem Grund. Wie in Fig. 10 gezeigt, bleibt dann in der Anschlußbohrung 11 ein nach innen in die Anschlußbohrung 11 gerichteter Kragen stehen, der eine Verengung 95 der Anschlußbohrung 11 bildet. Mithilfe dieser Verengung 95 wird der Anschlußpin 111 des betrachteten Bauteils 110 (siehe dazu Fig. 6-8) sicher festgeklemmt und das Bauteil 110 sicher auf der Leiterplatte 60 gehalten.

## Patentansprüche

1. Leiterplatte mit wenigstens einer Anschlußbohrung (11; 21) zur Aufnahme eines Anschlußdrahtes oder -pins (111) eines elektronischen Bauteils (110) mit einem vorgegebenen Draht- bzw. Pindurchmesser (112), wobei eine Haltevorrichtung (15; 25; 35; 45; 55; 65; 75; 85; 95; 101) zum Festhalten des Anschlußdrahtes oder -pins (111) vorgesehen ist, die eine Verengung in der Anschlußbohrung (11; 21) auf einen Durchmesser ist, der kleiner ist als der des Anschlußdrahtes oder -pins (111), **dadurch gekennzeichnet, daß** die Verengung (75; 85; 95) durch zwei Bohrungen (17, 36; 27, 46; 37, 56) herbeigeführt wird.

2. Leiterplatte nach Anspruch 1, **dadurch gekennzeichnet, daß** die Verengung (85) durch zwei gleichgerichtete Bohrungen (27, 46) mit unterschiedlichen Durchmessern herbeigeführt wird.

3. Leiterplatte nach Anspruch 1, **dadurch gekennzeichnet, daß** die Verengung (75; 85; 95) durch zwei gegenläufige Bohrungen (17, 36; 27, 46; 37, 56) herbeigeführt wird.

4. Leiterplatte nach Anspruch 3, **dadurch gekennzeichnet, daß** die Verengung (75) durch zwei gegenläufige und zueinander versetzte Bohrungen (17, 36) herbeigeführt wird.

5. Verfahren zum Herstellen einer Leiterplatte (60) mit wenigstens einer Anschlußbohrung (11) zur Aufnahme eines Anschlußdrahtes oder -pins (111) eines elektronischen Bauteils (110) mit einem vorgegebenen Draht- bzw. Pindurchmesser (112), **gekennzeichnet dadurch, daß**:
- die Leiterplatte (60) wird mit wenigstens einer Lage bzw. Schicht hergestellt;
- von einer Oberfläche der Leiterplatte (60) her wird mit einem Bohrwerkzeug mit einem Nenndurchmesser derart gebohrt, daß das Bohrwerkzeug die Leiterplatte (60) nicht vollständig durchstößt und so die Anschlußbohrung (11) in einem Bereich einen Querschnitt mit einem Durchmesser aufweist, der kleiner als der Draht- bzw. Pindurchmesser (112) des elektronischen Bauteils (110) ist, so daß von der dadurch hervorgerufenen Verengung (65) im Querschnitt der Anschlußbohrung (11) eine Haltevorrichtung zum Festhalten des Anschlußdrahtes oder -pins (111) gebildet wird.

6. Verfahren zum Herstellen einer Leiterplatte (60) mit wenigstens einer Anschlußbohrung (11) zur Aufnahme eines Anschlußdrahtes oder -pins (111) eines elektronischen Bauteils (110) mit einem vorgegebenen Draht- bzw. Pindurchmesser (112), **gekennzeichnet dadurch, daß**:
- die Leiterplatte (60) wird mit wenigstens einer Lage bzw. Schicht hergestellt;
- an der für die Anschlußbohrung (11) gewünschten Stelle wird mit einem Bohrwerkzeug mit einem gewünschten Durchmesser (12) ein Sackloch (46) in die Leiterplatte (60) gebohrt;
- anschließend wird mit einem mit einem Bohrwerkzeug mit einem Durchmesser, der kleiner ist als der Draht- bzw. Pindurchmesser (112), der Grund der Sacklochbohrung (46) mit einer zweiten Bohrung (27) durchbohrt, so daß durch die dadurch entstehende Verengung (85) des Querschnitts eines Teils der Anschlußbohrung (11) eine Haltevorrichtung zum Festhalten des Anschlußdrahtes oder -pins (111) gebildet wird.

7. Verfahren zum Herstellen einer Leiterplatte (60) mit wenigstens einer Anschlußbohrung (11) zur Aufnahme eines Anschlußdrahtes oder -pins (111) eines elektronischen Bauteils (110) mit einem vorgegebenen Draht- bzw. Pindurchmesser (112), **gekennzeichnet dadurch, daß**:
- die Leiterplatte (60) wird mit wenigstens einer Lage bzw. Schicht hergestellt;
- an der für die Anschlußbohrung (11) gewünschten Stelle wird von einer ersten Oberfläche der Leiterplatte (60) her mit einem Bohrwerkzeug mit einem gewünschten Durchmesser ein erstes Sackloch (17) in die Leiterplatte gebohrt;
- von einer zweiten Oberfläche der Leiterplatte (60) her wird ein zweites Sackloch (36) in die Leiterplatte (60) gebohrt, das zu dem ersten Sackloch (17) geringfügig verschoben angeordnet ist und das das erste Sackloch (17) trifft, so daß durch den Versatz der beiden Sacklöcher 17, 36) zueinander eine Restriktion (75) gebildet, die eine Haltevorrichtung zum Festhalten des Anschlußdrahtes oder -pins (111) darstellt.

8. Verfahren zum Herstellen einer Leiterplatte (60) mit wenigstens einer Anschlußbohrung (11) zur Aufnahme eines Anschlußdrahtes oder -pins (111) eines elektronischen Bauteils (110) mit einem vorgegebenen Draht- bzw. Pindurchmesser (112), **gekennzeichnet dadurch, daß**:
- die Leiterplatte (60) wird mit wenigstens einer Lage bzw. Schicht hergestellt;
- an der für die Anschlußbohrung (11) gewünschten Stelle wird von einer ersten Oberfläche der Leiterplatte (60) her mit einem Bohrwerkzeug mit einem gewünschten Durchmesser (12) ein erstes Sackloch (37) in die Leiterplatte (60) gebohrt;
- von einer zweiten Oberfläche der Leiterplatte (60) her wird ein zweites Sackloch (56) in die Leiterplatte (60) gebohrt, das zu dem ersten Sackloch (37) im wesentlichen achsparallel angeordnet ist und das das erste Sackloch (37) trifft aber nicht durchdringt, so daß in einem Teilbereich der Anschlußbohrung (11), wo die beiden Sacklöcher (37, 56) aufeinandertreffen eine Restriktion (95) gebildet wird, die eine Haltevorrichtung zum Festhalten des Anschlußdrahtes oder-pins (1119 darstellt.

9. Verwendung einer Leiterplatte (10; 20; 30; 40; 50; 60) nach einem der Ansprüche 1 bis 4 bzw. einer Leiterplatte (10; 20; 30; 40; 50; 60), die nach einem der Ansprüche 5 bis 8 hergestellt ist, mit wenigstens einem, mittels der Haltevorrichtung (15; 25; 35; 45; 55; 65; 75; 85; 95; 106) in der Anschlußbohrung (11) gehaltenen elektronischen Bauteil (110), das unter der Leiterplatte (10; 20; 30; 40; 50; 60) hängend in einem Reflow-Lötofen gelötet wird.

10. Verwendung einer Leiterplatte (10; 20; 30; 40; 50; 60) nach einem der Ansprüche 1 bis 4 bzw. einer Leiterplatte (10; 20; 30; 40; 50; 60), die nach einem der Ansprüche 5 bis 8 hergestellt ist, mit wenigstens einem, mittels der Haltevorrichtung (15; 25; 35; 45; 55; 65; 75; 85; 95; 106) in der Anschlußbohrung (11) gehaltenen elektronischen Bauteil (110) für ein Löten des Bauteils (110) in einem Wellen- Lötvorrichtung.

## Claims

1. A printed circuit board with at least one attachment bore (11; 21) for receiving an attachment wire or attachment pin (111) of an electronic component (110) with a pre-set diameter (112) of the wire or pin, wherein a holding device (15; 25; 35; 45; 55; 65; 75; 85; 95; 101) is provided for securing the attachment wire or attachment pin (111), the holding device (15; 25; 35; 45; 55; 65; 75; 85; 95; 101) being a narrowing in the attachment bore (11; 21) to a diameter which is smaller than that of the attachment wire or attachment pin (111), **characterized in that** the narrowing (75; 85; 95) is formed by two bores (17, 36; 27, 46; 37, 56).

2. A printed circuit board according to Claim 1, **characterized in that** the narrowing (85) is formed by two bores (27, 46) of different diameter which are orientated in the same direction.

3. A printed circuit board according to Claim 1, **characterized in that** the narrowing (75; 85; 95) is formed by two bores (17, 36; 27, 46; 37, 56) which extend in opposite directions.

4. A printed circuit board according to Claim 3, **characterized in that** the narrowing (75) is formed by two bores (17, 36) which extend in opposite directions and are offset with respect to each other.

5. A method of producing a printed circuit board (60) with at least one attachment bore (11) for receiving an attachment wire or attachment pin (111) of an electronic component (110) with a pre-set diameter (112) of the wire or pin, **characterized in that**
- the printed circuit board (60) is produced with at least one layer or coating;
- a bore is drilled with a drilling tool with a nominal diameter from a surface of the printed circuit board (60) in such a way that the drilling tool does not pass through the printed circuit board (60) completely and, in this way, the attachment bore (11) has in one region a cross-section with a diameter which is smaller than the diameter (112) of the wire or pin of the electronic component (110), so that a holding device for securing the attachment wire or attachment pin (111) is formed by the narrowing (65), formed as a result, of the cross-section of the attachment bore (11).

6. A method of producing a printed circuit board (60) with at least one attachment bore (11) for receiving an attachment wire or attachment pin (111) of an electronic component (110) with a pre-set diameter (112) of the wire or pin, **characterized in that**
- the printed circuit board (60) is produced with at least one layer or coating;
- a blind bore (46) is drilled by a drilling tool with a desired diameter (12) into the printed circuit board (60) at the location desired for the attachment bore (11);
- after that, the end of the blind bore (46) is drilled with a second bore (27) by a drilling tool with a diameter which is smaller than the diameter (112) of the wire or pin, so that a holding device for securing the attachment wire or attachment pin (111) is formed by the narrowing (85), formed as a result, of the cross-section of part of the attachment bore (11).

7. A method of producing a printed circuit board (60) with at least one attachment bore (11) for receiving an attachment wire or attachment pin (111) of an electronic component (110) with a pre-set diameter (112) of the wire or pin, **characterized in that**
- the printed circuit board (60) is produced with at least one layer or coating;
- a first blind bore (17) is drilled by a drilling tool with a desired diameter from a first surface of the printed circuit board (60) into the printed circuit board at the location desired for the attachment bore (11);
- a second blind bore (38), which is arranged slightly offset with respect to the first blind bore (17) and which meets the first blind bore (17), is drilled from a second surface of the printed circuit board (60) into the printed circuit board (60), so that a restriction (75), which forms a holding device for securing the attachment wire or attachment pin (111), is formed by the offset of the two blind bores (17, 36) with respect to each other.

8. A method of producing a printed circuit board (60) with at least one attachment bore (11) for receiving an attachment wire or attachment pin (111) of an electronic component (110) with a pre-set diameter (112) of the wire or pin, **characterized in that**
- the printed circuit board (60) is produced with at least one layer or coating;
- a first blind bore (37) is drilled by a drilling tool with a desired diameter (12) from a first surface of the printed circuit board (60) into the printed circuit board (60) at the location desired for the attachment bore (11);
- a second blind bore (56), which is arranged substantially axially parallel with respect to the first blind bore (37) and which meets but does not pass through the first blind bore (37), is drilled from a second surface of the printed circuit board (60) into the printed circuit board (60), so that a restriction (95), which forms a holding device for securing the attachment wire or attachment pin (1119 [*sic*], is formed in a portion of the attachment bore (11) where the two blind bores (37, 56) meet each other.

9. Use of a printed circuit board (10; 20; 30; 40; 50; 60) according to any one of Claims 1 to 4 or a printed circuit board (10; 20; 30; 40; 50; 60) which is produced according to any one of Claims 5 to 8, with at least one electronic component (110) which is held by means of the holding device (15; 25; 35; 45; 55; 65; 75; 85; 95; 106) in the attachment bore (11) and which is soldered in a suspended manner in a reflow soldering furnace below the printed circuit board (10; 20; 30; 40; 50; 60).

10. Use of a printed circuit board (10; 20; 30; 40; 50; 60) according to any one of Claims 1 to 4 or a printed circuit board (10; 20; 30; 40; 50; 60) which is produced according to any one of Claims 5 to 8, with at least one electronic component (110), which is held by means of the holding device (15; 25; 35; 45; 55; 65; 75; 85; 95; 106) in the attachment bore (11), for soldering the component (110) in a wave-type soldering apparatus.

## Revendications

1. Circuit imprimé pourvu d'au moins un trou de raccordement (11, 21) destiné à la réception d'un fil ou d'une broche de raccordement (111) d'un composant électronique (110) d'un diamètre de fil ou de broche (112) prédéfini, un dispositif de fixation (15 ; 25 ; 35 ; 45 ; 55 ; 65 ; 75 ; 85 ; 95 ; 101) étant prévu pour la fixation du fil ou de la broche de raccordement (111), lequel présente un rétrécissement dans le trou de raccordement (11, 21) à un diamètre, qui est inférieur à celui du fil ou de la broche de raccordement (111), **caractérisé en ce que** le rétrécissement (75 ; 85 ; 95) est généré par deux perçages (17, 36 ; 27, 46 ; 37, 56).

2. Circuit imprimé selon la revendication 1, **caractérisé en ce que** le rétrécissement (85) est généré par deux perçages (27, 46) de même sens et de diamètres différents.

3. Circuit imprimé selon la revendication 1, **caractérisé en ce que** le rétrécissement (75 ; 85 ; 95) est généré par deux perçages (17, 36 ; 27, 46 ; 37, 56) opposés.

4. Circuit imprimé selon la revendication 3, **caractérisé en ce que** le rétrécissement (75) est généré par deux perçages (17, 36) opposés et décalés l'un par rapport à l'autre.

5. Procédé destiné à la fabrication d'un circuit imprimé (60) pourvu d'au moins un trou de raccordement (11) destiné à la réception d'un fil ou d'une broche de raccordement (111) d'un composant électronique (110) d'un diamètre de fil ou de broche (112) prédéfini, **caractérisé en ce que** :
- le circuit imprimé (60) est fabriqué avec au moins une couche ;
- depuis une surface du circuit imprimé (60), l'on perce à l'aide d'un outil de perçage d'un diamètre nominal de telle sorte que l'outil de perçage ne traverse pas entièrement le circuit imprimé (60) et que le trou de raccordement (11) présente dans une zone d'une section, un diamètre inférieur au diamètre du fil ou de la broche de raccordement (112) du composant électronique (110), si bien que le rétrécissement (65) ainsi généré dans la section du trou de raccordement (11) constitue un dispositif de fixation destiné à maintenir le fil ou la broche de raccordement (111).

6. Procédé destiné à la fabrication d'un circuit imprimé (60) pourvu d'au moins un trou de raccordement (11) destiné à la réception d'un fil ou d'une broche de raccordement (111) d'un composant électronique (110) d'un diamètre de fil ou de broche (112) prédéfini, **caractérisé en ce que** :
- le circuit imprimé (60) est fabriqué avec au moins une couche ;
- un trou borgne (46) d'un diamètre (12) souhaité est percé à l'aide d'un outil de perçage dans le circuit imprimé (60), à l'endroit souhaité pour le trou de raccordement (11) ;
- ensuite, le fond du trou borgne (46) est percé à l'aide d'un outil de perçage, dont le diamètre est inférieur au diamètre du fil ou de la broche (112), par un deuxième perçage (27), si bien que par le rétrécissement (85) en résultant de la section d'une partie du trou de raccordement (11) est formé un dispositif de fixation destiné au maintien du fil ou de la broche de raccordement (111).

7. Procédé destiné à la fabrication d'un circuit imprimé (60) pourvu d'au moins un trou de raccordement (11) destiné à la réception d'un fil ou d'une broche de raccordement (111) d'un composant électronique (110) d'un diamètre de fil ou de broche (112) prédéfini, **caractérisé en ce que** :
- le circuit imprimé (60) est fabriqué avec au moins une couche ;
- un premier trou borgne (17) est percé dans le circuit imprimé (60) à l'aide d'un outil de perçage d'un diamètre souhaité, à l'endroit souhaité pour le trou de raccordement (11), à partir d'une première surface du circuit imprimé (60);
- un deuxième trou borgne (36) est percé dans le circuit imprimé (60), à partir d'une deuxième surface du circuit imprimé (60), lequel trou est légèrement décalé par rapport au premier trou borgne (17) et atteint le premier trou borgne (17) de telle manière à former par le décalage des deux trous borgnes (17, 36) un rétrécissement (75), qui constitue un dispositif de fixation destiné au maintien du fil ou de la broche de raccordement (111).

8. Procédé destiné à la fabrication d'un circuit imprimé (60) pourvu d'au moins un trou de raccordement (11) destiné à la réception d'un fil ou d'une broche de raccordement (111) d'un composant électronique (110) d'un diamètre de fil ou de broche (112) prédéfini, **caractérisé en ce que** :
- le circuit imprimé (60) est fabriqué avec au moins une couche ;
- un premier trou borgne (37) est percé dans le circuit imprimé (60) à l'aide d'un outil de perçage d'un diamètre (12) souhaité, à l'endroit souhaité pour le trou de raccordement (11), à partir d'une première surface du circuit imprimé (60) ;
- un deuxième trou borgne (56) est percé dans le circuit imprimé (60), à partir d'une deuxième surface du circuit imprimé (60), lequel trou est disposé pour l'essentiel parallèlement à l'axe du premier trou borgne (37) et atteint le premier trou borgne (37), cependant sans le traverser, de telle manière à former dans une zone partielle du trou de raccordement (11), où les deux trous borgnes (37, 56) se rencontrent, un rétrécissement (95), qui constitue un dispositif de fixation destiné au maintien du fil ou de la broche de raccordement (111).

9. Utilisation d'un circuit imprimé (10 ; 20 ; 30 ; 40 ; 50 ; 60) d'après l'une des revendications 1 à 4 ou d'un circuit imprimé (10 ; 20 ; 30 ; 40 ; 50 ; 60), qui est fabriqué d'après l'une des revendications 5 à 8, pourvu d'au moins un composant électronique (110) maintenu dans le trou de raccordement (11) au moyen du dispositif de fixation (15 ; 25 ; 35 ; 45 ; 55 ; 65 ; 75 ; 85 ; 95 ; 106), lequel composant (110), suspendu sous le circuit imprimé (10 ; 20 ; 30 ; 40 ; 50 ; 60), est soudé dans un four de soudage par refusion.

10. Utilisation d'un circuit imprimé (10 ; 20 ; 30 ; 40 ; 50 ; 60) d'après l'une des revendications 1 à 4 ou d'un circuit imprimé (10 ; 20 ; 30 ; 40 ; 50 ; 60), qui est fabriqué d'après l'une des revendications 5 à 8, pourvu d'au moins un composant électronique (110) maintenu dans le trou de raccordement (11) au moyen du dispositif de fixation (15 ; 25 ; 35 ; 45 ; 55 ; 65 ; 75 ; 85 ; 95 ; 106), lequel composant (110) est soudé dans une installation de soudage à la vague.
